(19) Europäisches Patentamt
European Patent Office
Office européen des brevets

(11) Publication number: **0 469 703 A2**

## EUROPEAN PATENT APPLICATION

(21) Application number: **91304565.4**

(22) Date of filing: **21.05.91**

(51) Int. Cl.5: **H05K 3/46**

(30) Priority: **31.07.90 US 560183**

(43) Date of publication of application:
**05.02.92 Bulletin 92/06**

(84) Designated Contracting States:
**BE CH DE ES FR GB IT LI NL**

(71) Applicant: **MACDERMID INCORPORATED**
**245 Freight Street**
**Waterbury, Connecticut 06702(US)**

(72) Inventor: **Donlon, Edward T.**
**501 Wood Creek Road**
**Bethlehem, Connecticut 06751(US)**

(74) Representative: **Pendlebury, Anthony et al**
**PAGE, WHITE & FARRER 54 Doughty Street**
**London WC1N 2LS(GB)**

(54) Multilayer printed circuits and process for their fabrication.

(57) Multilayer printed circuits, and methods for their fabrication, are provided, characterized in that the conductive circuitry of the circuitry innerlayers is built up from electroless copper, and the surfaces of the electroless copper which confront the sandwiching pre-preg resin layers are provided with a tin coating to promote adhesion of the electroless copper to the pre-preg resin layers. The invention is particularly suitable for preparing multilayer circuits having buried through-holes.

EP 0 469 703 A2

## BACKGROUND OF THE INVENTION

The present invention relates generally to the field of printed circuits, more particularly to the field of multilayer printed circuits, and still more particularly to the use of electrolessly-deposited copper as the conductive metal circuitry on patterned circuitry innerlayers of multilayered printed circuits, and the use of a tin coating as a means for promoting adhesion of the electroless copper circuitry of the innerlayers to the dielectric layers sandwiched about them in the multilayer circuit.

Multilayer printed circuits are well known in the art, and have come into increasing use over the past several years to satisfy an ever-increasing demand for high density circuitry and space/weight conservation.

Multilayer printed circuits are composed of an alternating array of innerlayers of conductive metal circuitry and layers of dielectric material, with the innerlayer circuits being in conductive interconnection by way of metallized through-holes. In the fabrication of multilayer printed circuits, a number of patterned circuitry innerlayers are prepared from dielectric substrate material which is clad on its opposed surfaces with a metal (almost universally copper) foil, via adhesives. The metal foil surfaces are formed into conductive circuitry patterns by subtractive printed circuitry, i.e., defining on the foil surface the positive of a desired circuit pattern by means of selective application of an etch-resistant material (e.g., an exposed and developed photoresist), followed by etching the surface down to the dielectric substrate material and removal of the resist to reveal the desired copper circuitry pattern. The multilayer circuit is then built up by sandwiching a so-prepared patterned circuitry innerlayer between one or more layers or sheets of partially cured dielectric material (typically referred to as "pre-preg" or "B-stage resin"), and continuing this interleaving of circuitry innerlayers and partially-cured dielectric layers for the desired number of layers. The composite is then subjected to heat and pressure to cure the partially-cured dielectric layers and bond circuitry layers to them, and thus to form an integral multilayer laminate. The multilayer laminate is then subjected to further processing steps to form the completed multilayer printed circuit, e.g., formation of conductive through holes, provision of patterned circuitry on one or both of the outer-facing surfaces of the laminate, and the like.

It is well known that the surface of the copper foil conductive innerlayer circuitry pattern which confronts the dielectric pre-preg or B-stage resin layer in forming the multilayer laminate exhibits poor bonding characteristics thereto. Accordingly, it is known in the art to treat the confronting patterned copper foil circuitry surface to improve its adhesion, in the heat/pressure bonding process, to the dielectric layer to which it is to be bonded. One common treatment is the provision of a copper oxide layer on the confronting copper foil circuit pattern surface, as by surface oxidation using a composition containing an alkali metal or alkaline earth metal chlorite and sodium or potassium hydroxide. See, e.g., U.S. Patent Nos. 4,409,037 and 4,844,981 to Landau. Also taught in the art is the provision of an immersion tin coating on the confronting copper foil circuit pattern surfaces. See, e.g., published European Patent Application 0 216 531.

At least in theory, the range of possible multilayer printed circuit configurations is unbounded, permitting of a wide variety of circuits having many layers, many complete through-holes, buried through-holes conductively interconnecting opposed surfaces of circuitry on selected circuitry innerlayers, and the like. Heretofore, however, such design possibilities have in practice been unable to be obtained in any reliable form or by any reliable fabrication technique. One difficulty in this regard is that many such designs would require utilization of circuitry innerlayers having a substantial copper foil thickness, but dielectric substrates with heavy (thick) copper foil cladding, from which such patterned circuitry innerlayers could be formed, are plagued by substantial non-uniformity in thickness. Difficulty also exists in the formation of suitable buried through-holes, i.e., through-holes which do not pass through the entirety of the multilayer circuit but rather connect circuitry surfaces on only selected innerlayer circuits in the multilayer array; these through-holes must of necessity be formed in the innerlayer circuits before assembly and bonding together of the multilayer laminate, and significant difficulty arises as a result of this need.

These difficulties can be alleviated by resort to the use of electrolessly deposited copper as the entirety, or at least a substantial portion, of the conductive metal innerlayer circuitry. Electrolessly deposited copper can be employed in providing metallized through-holes in individual circuitry innerlayers, and can be employed in the provision of conductive circuitry patterns of desired, uniform thickness. A substantial problem arises, however, in the bonding of such circuitry innerlayers to the sandwiching pre-preg or B-stage resin layers, inasmuch as the confronting electroless copper surfaces exhibit poor adhesion to these resin layers and such adhesion is not substantially improved by resort to the copper oxide technique so useful in treatment of circuitry surfaces formed, e.g., from substrates clad with rolled copper foil or electrolytic copper. These poor adhesion characteristics are of significant concern because delamination of circuitry innerlayers from the cured dielectric layers affects the integrity of the multilayer circuit. The effect is particularly pronounced in multilayer boards having numerous through-holes formed after assembly of the multilayer laminate. Copper oxide adhesion promoter is attacked by processing solutions employed in the through-hole metallizing process (the leaching of the copper oxide from innerlayer circuitry exposed at the through-holes results in what is commonly known as a "pink ring" around the hole area), with the result of extremely poor copper to dielectric bond strength at such areas and pronounced tendency to delamination.

## SUMMARY OF THE INVENTION

It is an object of the present invention to provide multilayer printed circuit laminates, and methods for their fabrication, which, by virtue of the ability to employ electroless copper for innerlayer circuitry while still achieving excellent adhesion between the innerlayers and the sandwiching resin layers, can be fabricated in any of a wide variety of configurations and formats, most notably with any number of desired buried through-holes.

Another object of the invention is to provide methods for improving the adhesion between electroless copper circuitry surfaces and resin layers.

According to one aspect of the present invention, it has been found that the limitations imposed on fabrication of multilayer printed circuits employing electrolessly deposited copper, i.e., wherein the metal circuitry surfaces confronting the sandwiching pre-preg or B-stage resin layers are composed of electroless copper, can be overcome by providing on the confronting electroless copper surfaces a layer comprised of tin, such as by immersion or electrolytic tin deposition. In the pressed together multilayer laminate, there is excellent adhesion between circuitry innerlayers and sandwiching resins, and the integrity of the bond is substantially unaffected by subsequent fabrication steps, e.g., the provision of metallized through-holes in the laminate which would otherwise lead to pink ring and delamination tendency in multilayer circuits if copper oxide were employed as an adhesion promoter on the electroless copper.

By reason of this ability to fabricate, with electroless copper circuit surfaces, well-bonded multilayer printed circuit laminates which are not prone to loss of physical/electrical integrity, the potential range and variety of multilayer printed circuits is greatly expanded, particularly those in which use is advantageously to be made of buried through-holes, i.e., through-holes which serve to conductively interconnect circuitry surfaces of only selected circuitry innerlayers or portions thereof within the multilayer circuit.

By way of illustration, the invention provides a process for fabricating multilayer printed circuits having one or more buried through holes in addition to through-holes which might be formed through the entirety of the multilayer circuit. In this process, an innerlayer circuit substrate is first provided, which may consist solely of a suitable thermoplastic or thermosetting dielectric, preferably with glass or other fiber reinforcement, or can consist of the dielectric already clad on both sides with a layer of copper, e.g., copper foil. In the latter case, the foil or layer cladding need not and should not be of the thickness of the eventually desired circuitry, since additional plating of electroless copper thereover will be carried out according to the invention.

The innerlayer substrate is then drilled through at the desired locations, and the so-produced through-holes are then metallized with electroless copper in known manner, e.g., activation of the through-hole surfaces with palladium-tin catalysts and electroless copper plating to predetermined thickness using any suitable electroless copper bath. During the process of through-hole metallization, of course, the planar surfaces of the innerlayer substrate are also built up with the electroless copper, i.e., over the dielectric surfaces or over any copper foil cladding layers previously thereon. According to one embodiment of the process, the extent of electroless copper deposition during the through-hole metallization is such that, as a consequence, a full-build of electroless copper to ultimately desired thickness of the circuitry is provided on the innerlayer.

Thereafter, the innerlayer substrate is imaged in the desired circuit pattern through utilization of a resist. Unprotected copper is etched away down to the dielectric substrate surface, and the resist then removed, producing a patterned circuit innerlayer having metallized through holes. According to the invention, the outer-facing electroless copper surfaces of the circuitry are then provided with a layer of tin to promote adhesion between the so-prepared circuitry innerlayer and the pre-preg or B-stage resin layers which will be sandwiched about it and which will be pressed together, with heat, in the later fabrication of the overall multilayer laminate.

Thereafter, assembly of the multilayer laminate proceeds according to conventional techniques, i.e., layering in registry of circuitry innerlayers and one or more pre-preg or B-stage resin layers, followed by pressure and heat to cure the partially cured resin layers and provide an integral laminate. Subsequent processing involves formation of through-holes, provision of circuitry patterns on the outer-facing surfaces of the multilayer composite, and the like.

As noted, the foregoing is merely illustrative of any number of multilayer printed circuit fabrication sequences and constructions which are enabled by the ability, provided in the present invention, to utilize electroless copper for building up of circuitry innerlayers without encountering the adhesion difficulties which would otherwise prevent useful resort to such expedients. Thus, it is within the contemplation of the inventive processes to fabricate the innerlayer circuits starting from unclad dielectric substrates or substrates already clad with a thin layer of copper in less than ultimately desired thickness; to fully build up a copper coating to desired circuitry thickness using electroless copper, followed by imaging and etching to produce the circuit pattern or, alternatively, to first build up a copper coating of less than ultimately desired thickness, followed by imaging and etching to form the pattern, followed by further electroless copper build up of the circuit pattern to desired thickness; and other like techniques.

Another significant advantage of the invention in enabling utilization of electroless copper is that uniform thicknesses of innerlayer copper circuitry are provided.

The layer of tin used to promote adhesion between the confronting electroless copper circuitry surface and the pre-preg or B-stage resin layers can, as noted, be applied by immersion plating or electrolytically, and preferably should be relatively thin, e.g., from about 1 to about 50 microinches.

## DETAILED DESCRIPTION OF THE INVENTION

In the fabrication of multilayer circuits according to the invention, use is made of so-called circuitry innerlayers and of pre-preg or B-stage resin layers (i.e., layers of partially cured polymeric material).

The circuitry innerlayers are themselves composed of conductive metal on a thermosetting or thermoplastic dielectric substrate material. Among the best known and most widely used dielectric substrate materials are epoxy and polyimide, although other resinous materials such as phenolics, cyanate esters, and the like also can be employed. As is often the case, the dielectric substrate material will also contain various fillers and/or reinforcing agents to improve physical and/or insulating properties, with glass reinforcement being typical.

The conductive circuitry of the innerlayers is built up on the opposed planar surfaces of the dielectric substrate. As noted, a common form of starting material for the innerlayers is copper foil-clad dielectric substrate, and in the invention the thickness of the foil cladding is selected to be quite minimal, i.e., less than the ultimately desired thickness of the circuitry. The starting material can also be the dielectric substrate per se (obtained in that form or by stripping of a foil-clad substrate), or can be a dielectric substrate with a thin copper layer cladding other than copper foil. Irrespective of the starting material, the ultimate aim is to provide by electroless copper the desired thickness of circuitry.

For the innerlayer circuitry, it will generally be the case that the circuitry on the dielectric substrate surfaces is fabricated in a predetermined pattern, but situations also exist where on one or both sides of the substrate the circuitry consists of simply an unpatterned layer of copper, as might be the case either for the outer facing surfaces of the ultimately constructed multilayer laminate, or as might be the case for provision of ground or shielding layers.

The primary focus of the invention is in the provision of multilayer circuits having hidden through-holes, i.e., metallized through-holes through the dielectric substrate for conductively interconnecting circuitry on opposite sides of the substrate, but which through-holes are not common to through-holes provided through the entirety of the multilayer printed circuit. Accordingly, the clad or unclad innerlayer substrate is drilled to provide through-holes therein at predetermined locations, and the through-holes are metallized via electroless copper. To this end, resort can be had to any of the known procedures for metallizing through-holes in double-sided printed circuit boards. Typically, the through-hole surfaces can be treated with a swellant or solvent for the dielectric material, followed by micro-roughening of the through-hole surface utilizing acids and/or oxidizing agents (followed if necessary by neutralization of any residual species which might interfere with subsequent catalyzing steps). The surfaces are then treated in known manner to deposit thereon species catalytic to the electroless deposition, such as by the tin/palladium activator sols or solutions known in the art (see, e.g., U.S. Patent Nos. 3,011,920 and 3,532,518), followed by acceleration if necessary (see, e.g., U.S. Patent No. 4,608,275 to Kukanskis and U.S. Patent No, 4,863,758 to Rhodenizer). The catalyzed surfaces are then electrolessly copper plated using any suitable electroless copper bath, typically containing a source of copper ions, a reducing agent (e.g., formaldehyde, hypophosphite), complexing agents and pH adjusters.

The foregoing steps for plating the through-holes are carried out on the entirety of the innerlayer substrate, i.e., its planar surfaces as well as its through-hole surfaces, and as such the planar surfaces are also built up with electroless copper during through-hole metallization, i.e., on the dielectric substrate surface per se or over a copper foil or other copper layer already provided thereon. The choice of electroless copper bath is not critical per se, but consideration must be given to the desired thicknesses to be produced on the through-hole and planar surfaces. Thus, if the plating is only required to be of minimal thickness (i.e., full build to ultimately desired thickness to be accomplished in subsequent processes), then it is possible to use both autocatalytic plating baths (baths in which the deposited electroless copper catalyzes further deposition from the bath) as well as non-autocatalytic baths (which become passive after deposit of a thin layer of electroless copper). Where a full build to ultimately desired thickness is required, however, the autocatalytic baths will be employed. Formaldehyde-reduced electroless copper baths are autocatalytic, while hypophosphite-reduced baths (see, e.g., U.S. Patent Nos. 4,209,331 and 4,279,948) are generally non-autocatalytic unless certain formulation and/or processing techniques are employed (see, e.g., U.S. Patent Nos. 4,265,943 to Goldstein et al.; U.S. Patent No. 4,459,184 to Kukanskis; and U.S. Patent No. 4,671,968 to Slominski). It is also appropriate to note here that by "electroless copper" as used herein, it is intended to include deposits which not only are copper per se but also deposits which are predominantly copper but which may also contain additional metals.

For patterning the circuitry on one or both sides of the innerlayer, use is made of etch-resistant materials provided on the electroless copper surfaces in the positive of the desired circuitry, either by screening of an organic resist in the pattern or, as is more typical, by application of a layer of photoresist, exposure through a patterned mask, and removal of exposed or unexposed areas as the case may be, to leave a positive of the circuit. The copper surface areas not covered by the resist are then etched away down to the dielectric substrate surface in known manner, and the resist removed to reveal the copper circuitry pattern. At this point, depending upon whether the electroless copper was used to build the circuitry to full thickness or whether a less than ultimately desired thickness was deposited, the copper circuitry may or may not require further deposition of electroless copper. When circuitry of desired thickness is obtained, the outer facing surfaces thereof, which will be bonded to sandwiching pre-preg or B-stage resin layers, are treated to provide a layer of tin thereon to promote adhesion.

The preferred method for tin application is through use of an immersion tin bath which deposits tin on the copper surface by replacement/exchange reaction. Such baths are well known in the art and contain tin salts, a strongly acidic medium (e.g., hydrochloric or sulfuric or fluoboric acids), chelating agents such as thiourea, and additional components such as hypophosphite ion. See, e.g., U.S. Patent No. 3,303,029. The requisite tin layer can also be applied by electrolytic processes. The thickness of the tin layer can be on the order of 3 to about 75 microinches, preferably from about 10 to about 30 microinches, and most preferably from about 15 to about 30 microinches.

The so-prepared innerlayer circuits, as well as other innerlayer circuits treated in similar manner, both with and without through-holes, are now ready (after, e.g., rinsing and drying) for assembly into a multilayer laminate. To this end, layers or sheets of partially cured dielectric material are employed for interleaving between the innerlayer circuits. The resins can be any of those earlier noted for use as the dielectric substrate material for the innerlayer circuits, and indeed it is preferable that the same dielectric material be employed throughout the multilayer printed circuit. These layers generally comprise a woven or non-woven layer or layers of fibers (e.g., glass) impregnated with a partially cured resin (B-stage epoxy resin or other equivalent curable resin). One or more of these partially-cured dielectric sheets can be arranged between circuitry innerlayers. When the final array of desired alternating layers in suitable registry is achieved, the composite is pressed under conditions sufficient to cure the partially-cured resin and achieve an integral bonded multilayer laminate structure.

The subsequent processing steps are well known in the art, including the provision of through-holes through the laminate, which are then metallized by steps typically including desmearing and/or etchback, application of through-hole conditioner, catalysis and electroless metal plating. During the course of this processing, additional electroless copper can be built up on the outer-facing surfaces of the multilayer laminate for use in provision of patterned circuitry thereon.

By proceeding in the foregoing manner, multilayer printed circuits can be fabricated which have any desired number of innerlayers of circuitry and any desired number of buried through-holes therein, with the additional advantages of circuitry of uniform thickness and, of course, a strongly bonded circuit having greatly reduced tendency to delamination.

The invention is further described and illustrated in the following examples.

EXAMPLE I

Through-hole-containing innerlayer circuits for assembly as portions of a multilayer printed circuit are prepared by drilling through-holes in a planar dielectric substrate composed of glass-reinforced epoxy (thickness, e.g., of anywhere from .006 to 0.30 inches). The substrate is immersed in a concentrated solution of dimethylformamide swellant, followed by rinsing and immersion in a chrome-sulfuric acid etch solution containing, e.g., 100-300 g/l chromic acid and 10-40% by volume sulfuric acid, for 5 to 10 minutes. The substrate is then immersed in a sodium bisulfite bath to reduce hexavalent chrome to trivalent chrome, and rinsed. The substrate is then cleaned in alkaline cleaner and rinsed.

The substrate is immersed in an activating solution containing palladium chloride, stannous chloride and hydrochloric acid to deposit catalytic species on the substrate, including through-hole surfaces, followed by acceleration in acid and rinsing. The substrate is then plated in a formaldehyde-reduced electroless copper bath (MaCudep 900, MacDermid, Inc., Waterbury, Connecticut) to the full desired thickness of 25 to 50 microns. The plated substrate surfaces are then imaged in desired pattern using a photoresist, and the unprotected copper surfaces then etched down to the substrate surface. The resist pattern is removed, and the circuitry innerlayer is then cleaned in alkaline cleaner, rinsed, immersed in an acidic pre-dip in preparation for immersion tin plating, followed by immersion into the tin bath at about 80-90° F for about 10 minutes to provide on the electroless copper an immersion tin layer about 20-30 microinches thick. The innerlayer is then rinsed and dried for about 30 minutes to one hour at 200-250° F. These and other innerlayers are then interleaved with B-stage epoxy resin pre-preg sheets (each about 3 to 6 mils in thickness) and pressed at about 300 psig and 350° F for form the integral bonded multilayer laminate.

EXAMPLE II

Through-hole containing innerlayer circuits for assembly as portions of a multilayer printed circuit are prepared by drilling through-holes in a copper foil-clad glass-reinforced epoxy board material (0.5 oz. copper). The through-holes were treated with concentrated dimethylformamide swellant, followed by rinsing, treatment with an alkaline potassium permanganate solution, rinsing, and neutralization of residual manganese species with hydroxylamine. The board is then mildly etched in persulfate solution, rinsed, and catalyzed as in Example I. The board is immersed in an electroless copper bath (MaCudep 900, MacDermid, Inc.) to deposit a thin layer of about 1-2 microns of electroless copper on the through-hole surfaces and over the copper cladding. After rinsing, the board is provided with further electroless copper (Prism Cu, MacDermid, Inc.) to the full desired thickness. Following generation of the desired circuit pattern (i.e., traces, pads) on both sides of the board by imaging, etching and stripping of the organic resist), the copper circuitry surfaces are lightly etched (e.g., 15-50 microinches), rinsed, immersed in an acid pre-dip, and immersion tin plated to provide a tin coating of about 15-30 microinches. After rinsing and oven drying at 200-250° F for one hour, the so-prepared innerlayer circuits are laminated with epoxy pre-preg resins and other innerlayer circuits, and the composite is pressed at about 340° F for 30 to 90 minutes, during which the heated resin softens and flows to fill voids between the panels and then cures to its final state, producing an integral, bonded laminate containing numerous circuitry innerlayers embedded therein, some containing through-holes.

## Claims

1. A process for the fabrication of a multilayer printed circuit, comprising steps wherein one or more substantially planar circuitry innerlayers, comprised of conductive metal circuitry on opposite planar surfaces of a dielectric substrate material, are each sandwiched between one or more substantially planar non-circuitry layers comprised of partially-cured dielectric material, followed by pressing together of the layers and inner-layers under conditions effective to cure the partially-cured dielectric material and bond together said layers and innerlayers to form an integral multilayer laminate, characterised in that the multilayer printed circuit is provided with buried metallized through-holes which conductively interconnect metal circuitry on opposed planar surfaces of the dielectric substrate material for one or more of said circuitry innerlayers, by a process comprising:

   (a) providing one or more through-holes in the dielectric substrate material;
   (b) metallizing the through-holes by electroless copper depositing, whereby electroless copper also is deposited on the planar surfaces of the dielectric substrate material;
   (c) forming a desired circuitry pattern on one or both of the electroless copper metallized planar surfaces of the substrate; and
   (d) providing on surfaces of the electroless copper circuitry on the planar surfaces of the substrate, which are to confront the said sandwiching layers of partially-cured dielectric material, a layer comprised of tin.

2. A process according to claim 1, wherein the dielectric substrate material of the circuitry innerlayer provided with through-holes is clad with a thin layer of copper at the time of formation and metallization of the through-holes, whereby the electroless copper deposited on the planar surfaces of the dielectric substrate material during the through-hole metallizing is deposited over the thin layer of copper.

3. A process according to claim 2, wherein the thin layer of copper is copper foil cladding.

4. A process according to claim 1, wherein, at the time of formation and metallization of the through-holes in the innerlayer, the planar surfaces of the dielectric substrate material consist solely of the dielectric material.

5. A process according to any one of the preceding claims, wherein the electroless copper deposited on the planar surfaces of the substrate during the metallizing of through-holes therein is of a thickness such that there is produced on the substrate the overall copper thickness desired for the innerlayer circuitry.

6. A process according to any one of claims 1 to 4, wherein the electroless copper deposited on the planar surfaces of the substrate during the metallizing of through-holes therein is of a thickness such that there is produced on the substrate copper circuitry of a thickness less than that desired for the innerlayer circuitry, and wherein, after the pattern formation of step (c) and prior to step (d), the innerlayer circuitry is built up to desired final copper thickness with electroless copper.

7. A process according to any one of the preceding claims, wherein the layer comprised of tin is of a thickness of from about 3 to 75 microinches.

8. A multilayer printed circuit, comprised of an integral bonded laminate of alternating (a) circuitry innerlayers composed of conductive metal circuitry on the opposed planar surfaces of a dielectric material, and (b) layers of cured dielectric material initially laminated in a partially-cured state, characterised in that (i) the circuitry of one or more of the said circuitry innerlayers is comprised of copper built up from electroless copper; (ii) surfaces of the said electroless copper which confront the said layer of cured dielectric material initially laminated in a partially-cured state, are provided with a coating comprised of tin; and (iii) one or more of the said circuitry innerlayers comprised of copper built up from electroless copper, has provided therein one or more through-holes, metallized with electroless copper, to conductively interconnect the circuitry on the opposed planar surfaces of the dielectric substrate material of said innerlayer, said through-holes being not common to through-holes formed through the entirety of the multilayer printed circuit.

9. A multilayer printed circuit according to claim 8, wherein the coating comprised of tin is of a thickness of from about 3 to 75 microinches.